# FASCICULE DE BREVET EUROPEEN

(11) **EP 4 294 969 B1**
(45) Date de publication et mention de la délivrance du brevet: **15.01.2025**
(21) Numéro de dépôt: 22706824.4
(22) Date de dépôt: 18.02.2022
(51) Int. Cl.: D03D 1/00, D03D 13/00, D03D 15/267, D03D 15/283

(54) **COMPOSANT EN TEXTILE AVEC ÉLECTRONIQUE IMPRIMÉE**
BEDRUCKTES ELEKTRONISCHES TEXTILBAUTEIL
PRINTED ELECTRONIC TEXTILE COMPONENT

(30) Priorité: 19.02.2021 FR 2101656
(43) Date de publication de la demande: 27.12.2023
(73) Titulaire: Porcher Industries, 38300 Eclose- Badinières (FR)
(72) Inventeur: ANDRIOLETTI, Florence, 01700 Miribel (FR); DALOD, Estelle, 38230 Pont de Cheruy (FR)
(74) Mandataire: Lavoix
(86) Numéro de dépôt international: PCT/EP2022/054143
(87) Numéro de publication internationale: WO 2022/175485

(56) Documents cités:
- EP-A1- 3 442 309
- WO-A1-2013/096356

## Description

La présente invention concerne un composant ayant des fonctionnalités électroniques, qui est notamment léger, durable et drapable.

EP 3 442 309 décrit un élément plan textile flexible électriquement conducteur comportant une impression d'encre conductrice, obtenue par application par sérigraphie d'une dispersion aqueuse de polymère contenant des particules électriquement conductrices sur une surface textile préalablement lissée, soit par calandrage à chaud, soit par application d'un polymère thermoplastique et calandrage à chaud, quoique cette solution y soit critiquée. Ce polymère est choisi parmi les polyesters, les polyamides, les polyoléfines, les polyuréthanes, PVC, polyacrylonitrile, alcool polyvinylique. La couche support textile peut être très diverse, comme un canevas, un tricot, un tissu tissé ou un molleton. Le document indique un poids de cette couche inférieur ou égal 250 g/m2, en particulier de 20 à 150 g/m2, de préférence de 40 à 100 g/m2. La liste des structures textiles utilisables, comme leur poids par unité de surface, ne dénote pas une prise en compte efficace de la problématique de produire un élément léger, drapable et durable. WO 2013/096356 A1 décrit un composant électronique drapable, comprenant une couche d'électronique formée par une impression d'encre et une couche de protection.

Un objectif de l'invention est de fournir un textile ayant des fonctionnalités électroniques, qui soit notamment léger, drapable et particulièrement durable, notamment résistant mécaniquement et chimiquement, notamment vis-à-vis des contraintes environnementales internes et externes, et notamment la présence d'eau et/ou de solvants organiques et/ou d'humidité ambiante et/ou d'oxygène de l'air.

Un objectif de l'invention est notamment de proposer un tel textile qui ne nécessite pas de prétraitement de la structure textile initiale avant encrage, tel qu'un lissage par calandrage ou l'application d'une couche primaire de polymère, tout en permettant d'imprimer des motifs très précis et durables.

D'autres objectifs de l'invention apparaîtront à la lecture de ce qui suit.

Le compromis entre durabilité, légèreté et drapabilité est difficile à obtenir. L'invention propose néanmoins un composant à fonctionnalités électroniques. Notamment, ce composant est tout à la fois léger, durable et drapable. Un composant électronique drapable est un composant électronique surfacique qui est suffisamment souple et déformable pour pouvoir revêtir un objet de forme volumique, en épousant le mieux possible cette forme volumique pour ainsi draper ledit objet. Néanmoins, le composant électronique drapable n'est pas obligatoirement utilisé pour revêtir un objet et peut avoir diverses applications. Le composant est durable, en ce sens que l'impression d'encre à fonctionnalité électronique, notamment conductrice, est protégée des contraintes mécaniques et des contraintes environnementales ou climatiques, notamment de l'humidité et de l'oxygène, afin d'assurer une bonne longévité au composant. En effet les métaux, comme les métaux conducteurs (à l'exception de l'or) réagissent à l'eau, à l'oxygène et /ou au soufre. Ainsi, les métaux conducteurs ont tendance à se dégrader avec le temps en semi-conducteurs, devenant beaucoup moins efficaces dans le déplacement de l'électricité. L'argent est notamment sujet aux effets de l'oxydation, en particulier dans les climats humides.

Le composant de l'invention comprend ainsi une couche de circuit électronique et une couche de protection. Une idée à la base de l'invention est de prévoir que la couche de protection soit à la fois une couche de protection et une couche de support, mais que la couche de circuit électronique soit directement au contact du textile. L'idée est d'éviter l'interposition d'une couche primaire (par exemple de polymère) ou un traitement de lissage, par exemple par calandrage, qui sont des solutions pouvant avoir des conséquences néfastes sur la résistance mécanique du textile en écrasant et en abîmant les fibres et pouvant avoir des conséquences néfastes sur la force et la durabilité d'adhésion entre l'encre et la surface textile calandrée ou recouverte d'un polymère thermoplastique, du fait par exemple d'une incompatibilité physico-chimique.

Ainsi, la couche de protection forme un complexe qui comprend un textile et une couche de polymère de protection, revêtant une face du textile, tandis que la couche de circuit électronique est déposée sur le textile, sur la face du textile opposée à la face de dépôt de la couche de polymère de protection. La couche de circuit électronique (ou couche d'électronique) est donc formée directement sur le textile. La couche de circuit électronique est avantageusement formée par une impression d'encre adaptée.

Dans la description qui suit, hors exemples, les valeurs numériques isolées ou dans un intervalle, recouvrent les valeurs indiquées stricto sensu, et les valeurs environnantes qu'un homme du métier considérera comme comprises dans la valeur numérique indiquée.

Le textile est un tissu obtenu par tissage de fils continus. Les caractéristiques ci-après sont celles du tissu après tissage, et en l'absence de modifications structurelles imposées par un traitement post-tissage comme le calandrage.

Le textile a une épaisseur comprise entre 25 et 500 µm, notamment entre 25 et 300 µm, en particulier entre 25 et 150 µm, plus particulièrement entre 25 et 50, 60 ou 70 µm.

Le textile est caractérisé par un taux de couverture sur 25 µm d'épaisseur supérieur ou égal à 0,5, typiquement de 0,5 à 3, notamment compris entre 0,6 et 2,5, en particulier compris entre 0,7 et 2, notamment entre 0,7 et 1,5, le TC25 étant calculé comme suit : TC25 = [(nombre de filaments/cm × diamètre d'1 filament en cm)_{chaîne} + (nombre de filaments/cm × diamètre d'1 filament en cm)ₜᵣₐₘₑ] × 25 / Epaisseur du textile mesurée en µm. Par nombre de filaments par cm, on entend le nombre de filaments constitutifs des fils en chaîne et en trame.

Dans un mode de réalisation, on utilise des tissus très fins, ayant notamment une épaisseur comprise dans les intervalles suivants : 25 à 70 µm, 25 à 60 µm, 25 à 50 µm. Pour ces tissus très fins, on peut caractériser le tissu par son taux de couverture global, ou TC, en plus ou à la place du TC25. Ce TC est notamment supérieur ou égal à 1,5, notamment compris entre 1,5 et 3, de préférence compris entre 1,8 et 3, le TC étant calculé comme suit : TC = (nombre de filaments/cm × diamètre d'1 filament en cm)_{chaîne} + (nombre de filaments/cm × diamètre d'1 filament en cm)ₜᵣₐₘₑ.

Les mesures de l'épaisseur des tissus sont réalisées à l'aide d'un micromètre selon la norme NF EN ISO 5084 avec une surface de palpeur circulaire de 2 cm² et une pression sur palpeur de 500 g/cm².

Suivant une caractéristique de l'invention, le tissu n'est pas calandré.

Le tissu peut avoir un poids compris entre 20 et 450 g/m², notamment entre 20 et 350 g/m², typiquement entre 20 et 250 g/m², en particulier entre 20 et 100 g/m².

Si le tissu est confectionné avec des fils synthétiques (par exemple polyamide, polyester), le nombre de fils au cm en chaîne et en trame est notamment compris entre 10 à 50 fils/cm, par exemple 20 ou 30 à 50 fils/cm.

Si le tissu est confectionné avec des fils inorganiques (par exemple verre, basalte) ou d'origine naturelle (par exemple cellulose et dérivés, lin), le nombre de fils au cm en chaîne et en trame est notamment compris entre 6 et 30, en particulier entre 8 et 30, notamment entre 10 et 25 fils/cm.

Le textile a une structure à la fois très peu épaisse et très dense, conduisant à un état de surface plan, propice à l'impression précise et durable d'encre conductrice. On peut ainsi facilement obtenir que la couche d'électronique imprimée se présente sous la forme d'un motif de résolution particulièrement élevée, c'est-à-dire constituée de surfaces ou d'éléments de dimensions très précises, et/ou particulièrement fins et complexes. Le composant électronique drapable peut ainsi présenter une haute résolution ou une haute précision dans la réalisation, selon l'application, pour la captation, l'émission de signaux électroniques, notamment électriques, ou la formation de circuits électroniques, notamment électriques, surfaciques.

Par ailleurs, la couche de protection combine un tel textile et une couche de polymère, cette combinaison permettant par ailleurs de conférer non seulement la drapabilité souhaitée, mais aussi la résistance mécanique du composant d'électronique imprimée permettant d'assurer la durabilité du composant, avec notamment une résistance mécanique, notamment une résistance à la fatigue mécanique et au déchirement, ainsi qu'une résistance chimique, notamment une étanchéité à l'eau, à l'humidité, à l'air, à la poussière et à l'oxygène. La couche d'électronique imprimée est ainsi particulièrement bien protégée des sollicitations mécaniques extérieures et des pollutions environnementales extérieures, et notamment des phénomènes d'oxydation. En outre, la couche de polymère confère à la couche de protection une meilleure tenue se traduisant par le fait que la couche de protection est moins déformable que le textile lors de ses manipulations, y compris lors de l'impression d'encre sur la face opposée, ce qui permet, d'une part, d'obtenir des pistes homogènes et bien délimitées, présentant de très bonnes propriétés électroniques, par exemple de conductivité, et, d'autre part, de fabriquer le composant par des procédés continus, par exemple du type rouleau à rouleau (roll-to-roll). La couche de protection apporte également une isolation électrique du composant en empêchant la diffusion de charges électriques au travers de la couche de protection.

La conductivité électrique caractérise l'aptitude d'un matériau à laisser les charges électriques se déplacer librement et donc permettre le passage d'un courant électrique. La conductivité électrique est l'inverse de la résistivité. Cette résistivité correspond à la résistance d'un matériau d'un mètre de longueur et de section d'un mètre carré. Elle est exprimée en ohmmètre ou ohmcentimètre (Ωm ou Ωcm). L'évolution de la résistivité peut varier en fonction de la température et dépend de la nature du matériau. Les métaux (cuivre, or, argent, aluminium, ...) ont des valeurs de résistivité les plus faibles à température ambiante, inférieure à 10⁻⁵ Ωcm. Les matériaux dont la résistivité est supérieure à 10⁸ Ωcm sont considérés comme isolant (comme le verre, le mica, la silice). Dans le cas des matériaux semi-conducteurs, la résistivité est comprise entre 10⁻³ Ωcm et 10⁴ Ωcm.

Le composant électronique drapable est de préférence obtenu à l'aide d'un procédé de fabrication incluant la fabrication de la couche de protection par dépôt du polymère sur une première face d'un textile, le séchage et la réticulation de ce polymère, puis seulement l'impression de l'encre sur l'autre face du textile. La couche de protection permet de favoriser le dépôt de l'encre sur la face opposée, la couche de protection ayant une tenue supérieure au tissu seul. Lorsque le tissu le permet de par sa bonne tenue lors de l'impression, on peut aussi procéder d'abord par l'impression d'encre, puis par le dépôt du polymère. De préférence, cette impression est effectuée par sérigraphie d'encre sur le textile, ou par la technologie offset.

L'invention a aussi pour objet ce procédé de fabrication et le produit obtenu par ce procédé.

### ➢ La couche de polymère :

La couche de protection (textile et polymère de protection) peut avoir un poids compris entre environ 21 et environ 700 g/m², typiquement entre environ 21 et environ 500 g/m², notamment entre environ 21 et environ 320 g/m², en particulier entre environ 21 et environ 130 g/m².

Le taux d'emport sec du polymère de protection peut notamment être compris entre 5 et 50%, de préférence compris entre 5 et 30 % en poids, mieux entre 10 et 30 %. Le taux d'emport sec est le ratio en poids du polymère de protection sec sur le textile.

La couche de polymère de protection peut être constituée ou comprendre un revêtement enduisant ou imprégnant le textile, le polymère pouvant notamment être déposé à la racle sur la face du textile dédiée, ou par d'autres techniques de dépose n'appliquant pas d'action mécanique sur le tissu susceptible d'en modifier significativement la structure. Elle peut aussi être formée d'un film rapporté et laminé sur le textile.

Dans le premier cas dans lequel le polymère enduit le textile, ce polymère peut notamment comprendre ou être constitué de : polyuréthane, polyester, polycarbonate, polyéther, polyéthylène, polypropylène, alcool polyvinylique, poly(acétate de vinyle), poly(éthylène-acétate de vinyle), poly(acrylate-méthacrylate), poly(chlorure de vinyle), caoutchouc synthétique, silicone, copolymères de ces polymères.

Dans un mode de réalisation particulier, le polymère est un polyuréthane (PU), et ce PU peut être avantageusement à base de polyéther, polyester ou polycarbonate.

Suivant une modalité particulièrement préférée, le polyuréthane est un PU réticulé à base polyéther, polyester ou polycarbonate, et ce PU est issu de la réticulation (1) d'un élastomère de polyuréthane monocomposant ayant un module à 100% d'allongement inférieur ou égal à 50 MPa, typiquement compris entre 1 et 50 MPa, notamment compris entre 1 et 40 MPa, en particulier entre 1 et 35 MPa, selon la norme DIN 53504, mis en oeuvre en phase solvant organique, (2) par un réticulant, à raison d'une proportion de réticulant sec par rapport à l'élastomère sec compris entre environ 5 % et environ 100 % en poids, notamment entre environ 7 et environ 80 % en poids, en particulier entre environ 8 et environ 75 % en poids.

Un polyuréthane comporte une partie raide (isocyanate) et une partie souple (polyol). L'homme du métier sait trouver le compromis entre le ratio isocyanate/polyol et la nature des composants pour obtenir l'élastomère de raideur voulue, caractérisée par le module à 100% d'allongement. De préférence, l'élastomère engagé dans la couche de polymère de protection est monocomposant, l'isocyanate ayant réagi sur le polyol, puis avec l'allongeur de chaîne ou l'agent réticulant, formant un élastomère renfermant généralement encore des fonctions réactives type NCO et alcool. L'homme du métier pourra se référer à la littérature sur la production de copolymères ou élastomères obtenus à partir d'isocyanate, de polyol et d'allongeurs de chaîne ou d'agent réticulant, en particulier à la Thèse en Matériaux Polymères et Composites de Ségolène Hibon, INSA de Lyon, France, 2006.

La composition d'enduction est de préférence complétée par un réticulant, en particulier un isocyanate ou une mélamine, ou encore un mélange des deux. Par isocyanate, on entend à la fois un isocyanate et un polyisocyanate, seul ou en mélange avec un ou plusieurs autres isocyanates et/ou polyisocyanates. Le terme « isocyanate" doit être compris ici comme regroupant les termes "isocyanate" et "polyisocyanate". Les polyisocyanates sont préférés. Pour ce qui est de la mélamine, il peut notamment s'agir de la mélamine proprement dite (1,3,5-triazine-2,4,6-triamine) ou d'un composé ou d'une résine contenant de la mélamine, par exemple une résine mélamine-formaldéhyde.

Suivant un mode de réalisation, le polyuréthane (et l'élastomère de départ) est à base polyéther. Notamment, le polyuréthane base polyéther est linéaire ou ramifié et comporte une partie polyol de type polyéther et une partie isocyanate.

Suivant un autre mode de réalisation, le polyuréthane (et l'élastomère de départ) est à base polyester. Notamment, le polyuréthane base polyester est linéaire ou ramifié et comporte une partie polyol de type polyester et une partie isocyanate.

Suivant un autre mode de réalisation, le polyuréthane (et l'élastomère de départ) est à base polycarbonate. Notamment, le polyuréthane base polycarbonate est linéaire ou ramifié et comporte une partie polyol de type polycarbonate et une partie isocyanate.

Pour ce qui est de l'élastomère et du réticulant, la partie isocyanate est de préférence aliphatique, en effet les isocyanates aromatiques ont notamment l'inconvénient de jaunir au cours du temps, ce qui les rends moins préférés, même s'ils sont utilisables.

Dans un mode de réalisation préféré, la couche de protection est obtenue par enduction de polyuréthane en phase solvant. L'étape d'enduction d'un polymère selon l'invention est effectuée par les techniques classiquement utilisées dans l'enduction des textiles, comme l'enduction directe. On entend par « enduction directe » une enduction par dépose directe, par exemple à l'aide d'une racle, d'un cylindre, par lame d'air, par foulard, à la barre Meyer (ou procédé Champion).

Notamment, on forme ou l'on part d'un élastomère monocomposant (formé notamment à partir de l'isocyanate, du polyol et de l'allongeur de chaîne ou de l'agent réticulant), en solution dans le solvant. Un film se forme naturellement lors de l'évaporation du solvant, et ce film peut être formé au contact du tissu dans le mode de réalisation où le tissu est enduit ou imprégné.

Le solvant du polymère est un solvant organique et peut notamment être choisi dans le groupe constitué par les solvants aromatiques, les alcools, les cétones, les esters, le diméthylformamide et la n-méthylpyrolidone. Dans un mode de réalisation particulier le solvant est choisi dans le groupe constitué par le toluène, le xylène, l'isopropanol, le butanol, le 1-méthoxypropane-2-ol, la méthyl éthyl cétone, l'acétone, la butanone, l'acétate d'éthyle, le diméthylformamide, la n-méthylpyrolidone, et un mélange d'au moins deux d'entre eux. Par exemple, un mélange de toluène et d'isopropanol.

Dans un mode de réalisation, le polyuréthane phase solvant peut être caractérisé par sa concentration comprise entre 20 et 50% en poids de PU non réticulé, notamment élastomère monocomposant, par rapport au mélange PU et solvant. Dans un mode de réalisation ce polyuréthane phase solvant, notamment l'élastomère en solution dans le solvant, peut être caractérisé par une viscosité inférieure à 100 000 mPa.s à 23 °C, de préférence comprise entre 5 000 et 60 000 mPa.s à 23 °C (norme DIN EN ISO/A3).

Le polymère, comme le PU, est séché et réticulé au contact du tissu. Notamment, l'étape de séchage et réticulation comprend d'abord le séchage, par exemple à une température comprise entre environ 90 et environ 120 °C, puis la réticulation à une température comprise entre environ 140 et environ 210° C.

La composition d'enduction du tissu de la présente invention peut comprendre en outre des additifs. Lesdits additifs peuvent être tout additif couramment employés dans les compositions d'enduction de tissus. Ils sont notamment choisis dans le groupe constitué par les modificateurs de viscosité, les stabilisateurs UV, les colorants et les dispersants.

Dans un mode de réalisation, le procédé comprend après séchage et réticulation, une ou plusieurs étape(s) de post-traitement conférant au tissu des propriétés anti-salissures et/ou déperlantes. On entend par traitement anti-salissure, un traitement à l'aide de produits anti-statiques et/ou anti-tack. On entend par traitement déperlant, un traitement à l'aide de résines fluorées avec ou sans réticulant de la résine fluorée, par exemple un isocyanate. Le traitement déperlant est suivi d'une étape de séchage/réticulation. Dans un mode de réalisation, le post traitement est appliqué par toute méthode connue de l'homme du métier et notamment par foulardage, enduction, pulvérisation ou traitement plasma.

Dans un autre cas, on prévoit que la couche de polymère est constituée par un film polymère laminé sur le textile. Autrement dit, la couche de protection est un stratifié drapable. La fabrication inclut donc une étape dans laquelle, pour fabriquer la couche de protection, on forme le complexe en superposant le textile non-revêtu (nu) avec le film polymère, que l'on presse à chaud ou que l'on colle pour obtenir le complexe.

Ce film de polymère peut notamment comprendre ou être constitué de : polyuréthane, polyester, polycarbonate, polyéther, polyéthylène, polypropylène, polychlorure de vinyle, polyfluorure de vinyle, poly(acrylate-méthacrylate).

Dans un mode de réalisation, comme film polymère laminé sur le textile, on emploie des films de polyuréthane ou de polyester ou des films à base de polyuréthane ou de polyester. Par film à base de polyuréthane, on entend un film qui comprend au moins un polymère comprenant au moins une fonction uréthane, de tels films peuvent par exemple comprendre du polyuréthane et au moins un autre constituant, par exemple au moins un autre monomère ou au moins un autre polymère ou comprendre au moins une fonction uréthane et au moins un autre constituant, par exemple au moins un autre monomère ou au moins un autre polymère. Ces films à base de polyuréthane sont généralement des copolymères.

De tels films à base de polyuréthane sont notamment des copolymères de polyuréthane avec au moins un autre polymère notamment de type polyéther et/ou polyamide. Ces copolymères sont de préférence des copolymères blocs. A titre d'exemple non limitatif on peut citer les copolymères polyuréthane-bloc-polyéther, les copolymères polyuréthane-bloc-polyamide et les copolymères polyuréthane-bloc-polyéther-bloc-polyamide.

Le polyuréthane est de préférence un polyuréthane à base polyéther, polycarbonate ou polyester aromatique ou aliphatique, de préférence aliphatique. Ainsi, le polyuréthane comporte une partie polyol de type polyéther ou polycarbonate ou polyester et une partie isocyanate aromatique ou aliphatique (linéaire ou ramifié). Dans un mode de réalisation particulier, le polyuréthane est un polyuréthane base polyéther aromatique. Dans un autre mode de réalisation, le polyuréthane est un polyuréthane base polyéther aliphatique. Dans un autre mode de réalisation, le polyuréthane est un polyuréthane base polyester aliphatique.

A titre d'exemple non limitatif, l'épaisseur d'un film, par exemple film polyuréthane ou polyester, est typiquement de l'ordre de quelques micromètres à quelques dizaines de micromètres, par exemple comprise entre environ 3 et environ 200 µm, notamment entre 3 et 100 µm, de préférence entre environ 5 et environ 60 µm. De façon avantageuse, le poids de ces films est compris entre environ 3 et environ 200 g/m², de préférence entre environ 5 et environ 100 g/m², plus particulièrement entre environ 10 et environ 60 g/m².

### ➢ Le textile

Suivant un mode de réalisation, le textile de la couche de protection est un tissu obtenu par tissage de fils continus. Ainsi, la fabrication de la couche de protection inclut la fourniture d'un tel tissu, ou le tissage d'un tel tissu. L'armure du tissu est choisie pour permettre l'obtention du TC25 et/ou du TC global mentionné *supra.* Comme armure, on pourra notamment retenir la toile et le satin, sans donc y être limité toutefois.

Dans ce cas où le textile est un tel tissu, le tissu considéré avant traitement (enduction, lamination, impression d'encre) est caractérisé par son taux de couverture précédemment mentionné. Ce taux de couverture correspond à des valeurs conférant au tissu une configuration suffisamment fermée pour former un bon état de surface pour l'impression d'encre, non détérioré par l'application de la couche de polymère sur l'autre face du textile. Il permet en même temps de limiter le taux d'emport du polymère ou d'employer des films de polymère de faible épaisseur, et d'obtenir des complexes très souples et des circuits électriques drapables.

La densité peut être la même en sens chaîne et trame, ou elle peut être différente.

De préférence, les fils formant le tissu sont multifilamentaires. Ils sont formés de multiples filaments continus. Les fils peuvent être des fils en matériau organique, naturel, synthétique ou artificiel, notamment polyamide, notamment PA 6.6, ou polyester, notamment PET, ou des fibres inorganiques non conductrices, notamment verre (par exemple, verre E ou verre S).

Suivant un mode de réalisation, le tissu comporte des fils de chaîne et des fils de trame en matériau synthétique (par exemple polyester ou polyamide). Ces fils peuvent avoir un titre (masse linéique) en dtex compris entre environ 11 et environ 800 dtex, typiquement entre 11 et 300 dtex, notamment entre environ 22 et environ 110 dtex, en particulier entre environ 22 et environ 78 dtex. La masse linéique des filaments constitutifs (DPF ou decitex par filament) est notamment comprise entre 1 et 4, de préférence entre 1,3 et 3,5 dtex.

Suivant un autre mode de réalisation, le tissu comporte des fils de chaîne et des fils de trame en matériau inorganique ou en matériau naturel. Comme matériau inorganique on citera notamment le verre et le basalte. Comme matériau naturel, on citera notamment les fils en matériau biosourcé, par exemple lin ou cellulose. Les fils ont notamment un titre (masse linéique) compris entre environ 2 et environ 300 tex, typiquement entre environ 2 et environ 100 tex, notamment entre environ 10 et environ 90 tex, en particulier entre environ 20 et environ 80 tex. La masse linéique des filaments constitutifs (TPF ou tex par filament) est notamment comprise entre 0,05 et 0,2.

Dans un mode de réalisation, les fils de chaîne et les fils de trame sont de même titre et de même DPF ou TPF.

Selon un mode de réalisation particulièrement bien adapté, le tissu est formé de fils en PET. Le PET est constitué d'unités répétées de téréphtalate d'éthylène ; toutefois, entrent dans le champ de l'invention des variantes comportant une quantité minoritaire d'autres unités, par exemple moins de 10% molaire, notamment moins de 5 % molaire d'autres unités, par chaîne moléculaire du polyester (les comonomères pour former ces autres unités comprennent, par exemple, l'acide isophtalique, les acides naphtalène dicarboxyliques, l'acide adipique, les acides hydroxybenzoïques, le diéthylène glycol, le propylène glycol, l'acide trimellitique et le pentaérythritol).

Les fils de polyester, notamment PET, sont multi filamentaires. Ils sont formés de multiples filaments continus. Suivant un mode de réalisation, le tissu comporte des fils de chaîne et des fils de trame qui ont un titre en dtex compris entre 11 et 44 dtex, par exemple entre 11 et 33 dtex, avec notamment un DPF (decitex par filament) compris entre 1 et 4, de préférence entre 1,3 et 3,5.

Dans un mode de réalisation, les fils de chaîne et les fils de trame sont de même titre et de même DPF.

Les fils de PET sont multi filamentaires. Ils peuvent avoir notamment une, deux ou les trois caractéristiques suivantes : température de transition vitreuse : 60 à 90 °C, de préférence de 70 à 80 °C ; point de fusion : 240 à 270 °C, de préférence de 250 à 260 °C ; contrainte à la rupture : 3 à 7 cN/dtex, de préférence de 6 à 7 cN/dtex. De manière préférée, le fil de PET a les trois caractéristiques précitées.

La ténacité (ou résistance à la traction) des fils de PET et de PA6.6 est notamment supérieure ou égale à 6 cN/dtex, en particulier comprise entre 6 et 7 cN/dtex. Leur allongement à la rupture est notamment supérieur ou égal à 20%, en particulier compris entre 20 et 30 %. Ténacité et allongement à la rupture sont mesurés selon la norme NF EN ISO 2062.

Des fibres ou fils de PET ayant ces caractéristiques sont accessibles commercialement et/ou peuvent être produits à façon.

Le tissu peut être ensimé ou encollé, avant son incorporation dans la couche de protection. Cet ensimage ou cet encollage du textile peut être retiré, notamment par lavage ou par traitement thermique, pour favoriser l'adhésion de l'encre.

Le tissu, par exemple le tissu désensimé ou désencollé, peut subir un traitement pour favoriser l'adhésion de l'encre au tissu. On peut améliorer l'accroche de l'encre en appliquant au préalable, par exemple au tissu désensimé ou désencollé, un traitement d'apprêt. Il peut s'agir d'un traitement physique ou d'un traitement chimique dit traitement d'accroche. Ce traitement peut être, par exemple, un traitement corona ou un traitement par plasma ou un traitement chimique permettant d'augmenter l'énergie de surface du textile pour améliorer le mouillage du textile par l'encre. Ce traitement peut être, par exemple, un traitement corona ou un traitement par plasma ou un traitement chimique apportant des groupements fonctionnels susceptibles de réagir avec des groupements de l'encre pour former des liaisons chimiques.

Lorsque le tissu est formé de fils en matériau organique, il peut être avantageusement thermofixé. La thermofixation permet d'éviter un retrait lors du séchage de l'encre. La thermofixation est effectuée de 160 à 180°C pour les tissus à base de fibre polyamide et de 200 à 210°C pour les tissus à base de fibre polyester, les tissus étant maintenus sous tension dans le sens chaîne et dans le sens trame dans un procédé statique ou continu. Cette thermofixation favorise aussi l'impression d'encre régulière grâce à une meilleure tenue, notamment en procédé rouleau à rouleau.

Le composant de l'invention peut notamment avoir les spécifications suivantes :
un poids total compris entre environ 22 et environ 1400 g/m², notamment entre environ 22 et environ 620 g/m², en particulier entre environ 22 et environ 280 g/m² ; et/ou
un poids de la couche de protection compris entre environ 21 et environ 700 g/m², notamment entre environ 21 et environ 320 g/m², en particulier entre environ 21 et environ 130 g/m².

Un composant de poids et d'épaisseur dans la gamme haute des spécifications a des résistances mécaniques au-délà des attendus, une drapabilité conforme et une souplesse conforme pour les applications envisagées. A contrario, un composant de poids et d'épaisseur dans la gamme basse des spécifications a des résistances mécaniques conformes, une drapabilité et une souplesse au-délà des attendus pour les applications envisagées. La durabilité dépend de l'intensité et de l'angle de courbure des sollicitations en fatigue mécanique du composant électronique lors de son utilisation. Pour des sollicitations d'intensité élevée et d'angle de courbure faible, un composant de poids et d'épaisseur dans la gamme haute des spécifications sera préféré. Pour des sollicitations d'intensité moindre et d'angle de courbure élevé, un composant de poids et d'épaisseur dans la gamme basse des spécifications sera préférée.

### > L'encre :

L'épaisseur de l'encre déposée est comprise entre 1 et 150 µm, en particulier entre 2 et 50 µm, de préférence entre 5 et 30 µm. L'encre peut être appliquée en une seule couche, ou en plusieurs couches successivement appliquées. Les couches successives peuvent être dans un même matériau, ou dans des matériaux différents compatibles entre eux. La couche de protection peut être totalement recouverte ou l'encre peut former des motifs géométriques simples ou complexes sur la couche de protection.

Dans un mode de réalisation particulier, pour une encre à base d'argent, de viscosité 13000 mPa.s, déposée par sérigraphie et notamment pour une couche de protection de TC 25 égal à 0,8, la résolution maximale en largeur d'encre déposée, c'est-à-dire la largeur minimale des pistes peut atteindre 1 mm, voire 0,5 mm. La résolution maximale entre deux pistes d'encre déposée, c'est-à-dire la distance minimale entre deux pistes d'encre peut atteindre 1,5 mm, voire 1 mm.

Les encres peuvent comprendre un polymère ou copolymère en phase solvant, par exemple un PU en phase solvant.

L'encre est une encre qui apporte la fonctionnalité électronique souhaitée. Il peut s'agir notamment d'une encre conductrice, d'une encre semi-conductrice ou d'une encre diélectrique.

Une encre conductrice est une encre conçue pour conduire l'électricité, comme cela est connu en soi. Suivant un mode de réalisation, la résistance électrique est constante. Suivant un autre mode de réalisation, la résistance électrique est piézorésistive : dans ce cas la résistance électrique varie par application et/ou variation d'une contrainte mécanique sur la couche de protection, par exemple une pression. Suivant un autre mode de réalisation, la résistance électrique est thermorésistive : dans ce cas la résistance électrique varie en fonction de la température de la couche de protection.

D'autres applications connues de l'homme du métier existent et pourront être transposées sur la couche de protection ou le composant selon l'invention.

Pour l'ensemble de ces modes de réalisation, l'encre conductrice peut comprendre des particules conductrices ou électroactives telles que des particules métalliques organiques ou minérales, par exemple des particules d'argent ou comprenant de l'argent et/ou des particules de cuivre ou comprenant du cuivre et/ou des particules de carbone ou comprenant du carbone. L'encre conductrice peut également comprendre des polymères organiques conducteurs ou électroactifs et/ou des polymères organiques-inorganiques conducteurs ou électroactifs.

Notamment, les matériaux conducteurs sont des nano- ou micro-particules de métal, les matériaux semi-conducteurs sont des oxydes métalliques, des polymères organiques ou des semi-conducteurs inorganiques. Les encres conductrices fonctionnelles sont avantageusement développées à partir de métaux tels que le cuivre ou l'argent, d'oxides métalliques, de polymères conducteurs, d'organométalliques, de graphène, de nanotubes de carbone.

Les matériaux diélectriques sont notamment des polymères en phase solvant, des polymères thermodurs (thermodurcissables) ou des polymères organiques, qui sont additionnés de céramiques sous forme de microparticules et/ou de nanoparticules

L'encre fonctionnelle permet de disperser des matériaux conducteurs, semi-conducteurs ou diélectriques afin de faciliter leur dépôt sur support flexible, notamment par évaporation de solvant. On prévoit que l'encre est apte à passer d'un état dans laquelle l'encre peut être imprimée, par exemple liquide, vers un état où ladite encre conductrice est fixée sur le tissu, en étant alors dans un état figé. De préférence, l'encre fixée sur le tissu est souple, voire élastique, et suffisamment flexible pour accompagner une mise en place ou une déformation du composant électronique imprimée drapable.

Plus d'informations sur les encres peuvent être trouvées dans Tseghai et al. Integration of Conductive Materials with Textile Structures, an Overview, 3 December 2020, Sensors 2020, 20, 6910; doi:10.3390/s20236910*.*

Le dépôt d'encre peut être réalisé par tous moyens, tel que par exemple une projection ou une impression par jet d'encre, une pulvérisation sélective ou au travers d'un masque, ou encore une sérigraphie ou la technologie offset.

Le dépôt d'encre peut également être réalisé par transfert du motif d'encre conductrice d'un support de transfert vers le textile, le dépôt d'encre conductrice étant préalablement réalisé sur le support de transfert par tous moyens d'impression.

L'impression d'encre conductrice sur le tissu est de préférence effectuée par sérigraphie ou par offset.

Pour fixer l'encre une fois imprimée, selon le type d'encre, on a préférentiellement recours à une étape de séchage de l'encre ou de réticulation ou polymérisation de l'encre par chauffage ou rayonnement ultraviolet.

### ➢ Deuxième couche de protection, optionnelle

La couche de circuit électronique, formée par une impression d'encre sur le textile, peut être recouverte par une deuxième couche de protection.

La deuxième couche de protection comprend ou est constituée d'un polymère. Le revêtement de polymère peut notamment comprendre ou être constitué de : polyuréthane, polyester, polycarbonate, polyéther, polyéthylène, polypropylène, alcool polyvinylique, poly(acétate de vinyle), poly(éthylène-acétate de vinyle), poly(acrylate-méthacrylate), poly(chlorure de vinyle), caoutchouc synthétique, silicone, copolymères de ces polymères.

Le polymère utilisé pour cette deuxième couche de protection peut être un polymère tel que décrit à propos de la première couche de protection. Dans un mode de réalisation, le même polymère est utilisé dans les deux couches.

Comme pour le cas de la première couche de protection, on pourra utiliser un polyuréthane à base polyéther, polyester ou polycarbonate, et tout particulièrement un PU issu de la réticulation (1) d'un élastomère de polyuréthane monocomposant ayant un module à 100% d'allongement inférieur ou égal à 50 MPa, notamment compris entre 1 et 40 MPa, en particulier entre 1 et 35 MPa, selon la norme DIN 53504, mis en oeuvre en phase solvant organique, (2) par un réticulant, à raison d'une proportion de réticulant sec par rapport à l'élastomère sec compris entre environ 5 % et environ 100 % en poids, notamment entre environ 7 et environ 80 % en poids, en particulier entre environ 8 et environ 75 % en poids.

Cette deuxième couche de protection peut être appliquée, puis séchée et réticulée.

La deuxième couche de polymère de protection peut aussi être constituée par un film laminé sur le textile, comme cela est aussi décrit pour la première couche de protection.

L'ensemble des caractéristiques décrites à propos du polymère de la première couche de protection sont applicable à cette deuxième couche, sans qu'il soit besoin de les répéter ici.

### ➢ Utilisation

Le composant à fonctionnalité électronique drapable est notamment destiné à être appliqué sur un support ou objet, en étant orienté de préférence de manière que l'encre soit côté support ou objet, et la couche de protection soit côté opposé, tournée vers l'extérieur. Le support peut être un support matériel (par exemple équipement) ou un support vivant (par exemple humain, animal, végétal).

Ainsi, l'invention concerne également un élément d'habillage comprenant au moins un tel composant drapable, qui est configuré pour habiller au moins partiellement un support ou objet, par exemple du type décrit au paragraphe précédent.

L'invention concerne encore un objet portant à sa surface un tel composant drapable, ledit composant étant appliqué sur une surface de l'objet avec la couche d'électronique côté surface.

Les motifs d'impression d'encre permettent de conférer les propriétés électroniques ou électriques recherchées pour telle ou telle application, comme cela est connu en soi.

On peut ainsi utiliser le composant électronique de l'invention pour ses effets résistif, capacitif ou inductif comme des capteurs, des actuateurs, des antennes pour le stockage et la transmission de données, le blindage électromagnétique, comme composant optronique, comme piste électriquement conductrice pour l'utilisation ou la mise en contact de composants électroniques, en particulier LED ou OLED, puces RFID ou NFC, en tant que composants électroniques dans des films photovoltaïques flexibles, en tant que composants électroniques dans des applications OLED flexibles, comme système alternatif permettant l'économie d'énergie.

Dans le cas d'une connexion filaire ou d'une électronique secondaire embarquée dans le composant, le composant à électronique imprimée drapable comporte avantageusement un connecteur intégré, conçu pour être connecté de façon amovible avec la connexion filaire ou à un connecteur correspondant appartenant à l'électronique secondaire, ou à un fil de connexion de l'électronique avec le circuit électronique drapable, les signaux électroniques ou électriques transitant par l'intermédiaire de ces connecteurs.

Le composant électronique de l'invention présente une légèreté, une résistance mécanique élevée et une durabilité élevée et des propriétés barrières notamment vis-à-vis de l'oxygène de l'air, de l'humidité et de la présence d'eau, tout en restant souple et drapable. De plus la couche de protection confère au composant électrique de l'invention une propriété barrière aux charges électriques, donc une isolation électronique ou électrique.

L'invention va être maintenant décrite plus en détail à l'aide d'exemples de réalisation pris à titre non limitatif.

### Méthodes et mesures employées dans la demande (caractéristiques de l'invention et exemples) :

Dans les exemples, et pour la définition de l'invention, on utilise les méthodes suivantes, tandis que d'autres sont mentionnées ailleurs dans cette description.

L'influence de l'enduction sur la propriété barrière aux charges électriques a été évaluée par la méthode suivante. La résistance des pistes imprimées est évaluée grâce à un ohmmètre mis en contact d'un bout à l'autre de la piste d'encre conductrice imprimée. La mesure de référence est celle en contact direct avec l'encre, sur le recto du tissu. Il s'agit ensuite de retourner le composant pour mettre l'ohmmètre en contact indirect avec les pistes conductrices, c'est-à-dire sur le verso du tissu (enduit ou non) au droit des bouts de la piste. Le multimètre utilisé peut être un Fluke-115 ou un autre modèle dont les caractéristiques sont les suivantes :
- Résistance absolue maximum : 40MΩ
- Résolution de mesure de résistance : 100mΩ
- Précision de mesure : ± 0,9% + 2 counts. Par exemple pour 10 ohms mesurés, la précision est de 0,3 ohms (0,09 + 0,2 soit 0,29 ohms soit 0,3 ohms).

Plus la résistance électrique mesurée est basse, plus la conductivité électrique est élevée.

La résistance mécanique à la déchirure a été mesurée dans le sens chaîne et dans le sens trame conformément à la norme NF EN ISO 13934-1 : Textiles - Propriétés des étoffes en traction - Partie 1 : détermination de la force maximale et de l'allongement à la force maximale par la méthode sur bande. Les essais de traction ont été effectués en utilisant : vitesse de déplacement de la traverse, fixée à 100 mm/min et l'écartement entre les deux pinces de fixation est de de 200 mm ; la prétention est de 2N.

NF EN ISO 2062 - Détermination de la force de rupture et de l'allongement à la rupture des fils individuels à l'aide d'un appareil d'essai à vitesse constante d'allongement, utilisation de la Méthode A de la norme.

Force de rupture (unité centiNewton - cN) : force maximale développée pour rompre l'échantillon lors d'un essai de traction conduit jusqu'à la rupture.

Allongement à la rupture (%) : accroissement de la longueur de l'échantillon mesuré à la rupture de ce dernier.

Ténacité (cN/tex) : quotient de la force de rupture exprimée en cN par la masse linéique du fil exprimée en dtex (1 tex = 1 g pour 1000 m de longueur de fil).

Le test permet de mesurer la force et l'allongement à rupture de l'échantillon, grandeurs caractéristiques du fil.

Le fil est placé entre deux pinces de fixation, distantes de 500 mm. L'appareil (Dynamomètre) éloigne alors les pinces l'une de l'autre à une vitesse de déplacement constante de 500 mm/min et mesure la force appliquée en continu. La force nécessaire pour casser le fil est mesurée ainsi que l'accroissement de longueur du fil lors de la rupture. Force de rupture moyenne et allongement moyen à la rupture sont les deux données caractérisées par ce test. La ténacité est calculée à partir de la force de rupture rapportée à la masse linéique.

Le module à 100% d'allongement de l'élastomère de polyuréthane monocomposant est mesuré selon la norme DIN 53504. Le module est défini au 3.4 de la norme « Spannungswerte ». La mesure est réalisée sur des éprouvettes en forme d'haltère (Schulterstab) de type S2, avec cependant une longueur de barre I_{S} de 55 mm et une épaisseur de 200 µm. L'équipement utilisé est un dynamomètre. L'éprouvette haltère est placée dans les pinces de fixation, espacées d'une longueur L₀ avec le minimum de pré-tension possible. Les pinces sont alors éloignées les unes des autres à vitesse constante de 400 mm/min et le dynamomètre mesure la force appliquée en fonction de l'allongement. Le module ou contrainte à 100% d'allongement en MPa est le rapport force mesurée à 100% d'allongement sur la section initiale de l'éprouvette. Ceci est décrit au paragraphe 9.4 Spannungswerte de la norme DIN 53504.

La porosité est, et a été mesurée à neuf et après vieillissement conformément à la norme NFG 07111 ou à la norme NF EN ISO 9237 - Détermination de la perméabilité à l'air des étoffes, cette dernière remplaçant la précédente, mais donnant des résultats identiques. L'échantillon est monté sur un porte-échantillon circulaire. Une aspiration se lance afin de créer une dépression de 2000 Pa qui induit un flux d'air à travers l'échantillon. Le débit de ce flux est mesuré et donné en L/m²/min.

Pour le vieillissement, on mesure également la porosité du tissu après hydrolyse. Pour ce faire on place le tissu pendant 4 heures dans un autocuiseur Cocotte minute (« pressure cooker ») avec de l'eau à température et pression de fonctionnement. On applique ensuite 1 h de traitement en faisant flotter à l'air libre et à grande vitesse le tissu fixé sur un montage de type moulin (montage à 4 pales, le tissu étant fixé au bout d'une des pales).

Pour le vieillissement aux UV et à l'humidité (condensation), les normes de référence sont :
- ISO 11507:2007 Peintures et vernis - Exposition des revêtements au vieillissement artificiel - Exposition au rayonnement de lampes à fluorescence UV et à l'eau.
- DIN EN 12224: Geotextiles and geotextile-related products - Détermination of the résistance to weathering.

### Exemple 1 : Illustration de la propriété barrière aux charges électriques

Cet exemple compare les caractéristiques d'un tissu polyamide, imprimé par une encre conductrice sur une face et recouvert d'une enduction polyuréthane sur la face opposée (composant selon l'invention), par rapport à un tissu polyamide (témoin) imprimé par une encre conductrice et non-enduit sur la face opposée. Dans cet exemple, le PU a été déposé en premier sur une face du tissu, et durci, puis l'encre a été déposée sur l'autre face.

L'encre conductrice est l'encre argent Electrodag-725A de Henkel. Cinq pistes parallèles de 250 mm de long et 1 mm de large ont été imprimées par sérigraphie sur les deux tissus, le témoin et le composant selon l'invention. Le pas ou distance interligne est d'une dimension de 3 mm. L'épaisseur du dépôt d'encre conductrice est de 12 µm. La valeur théorique de la résistance ohmique de l'encre conductrice pour ces dimensions est de 0.015*(250/25/12) = 7,8 Ohms.

Le témoin est un tissu PA6.6 d'épaisseur environ 70 µm. La ténacité du fil PA6.6 est de 6,6 cN/dtex. L'allongement à la rupture est de 26%.

Dans le composant selon l'invention, le même tissu PA6.6 a une couche de protection par enduction polyuréthane obtenue à partir d'un élastomère de PU ayant un module à 100% d'allongement de 2 MPa et de réticulant isocyanate + mélamine formaldéhyde. La proportion de réticulant sec par rapport à l'élastomère sec est de 8,4%. Le polyuréthane est mis en oeuvre dans un mélange 50/50 de toluène et d'isopropanol.

Le PU est un PU monocomposant à base de polycarbonate aliphatique. L'enduction est réalisée en utilisant une racle et est suivie d'un séchage à 100°C, puis d'une réticulation à 180 °C.

**[Table 1]**

| | Témoin | Composant selon l'invention, exemple 1 |
|---|---|---|
| Nature du fil | PA6.6 | PA6.6 |
| Titre (dtex) | 33 | 33 |
| DPF (dtex) | 2,5 | 2,5 |
| Diamètre d'un filament (µm) | 19 | 19 |
| Nombre fils de chaîne x fils de trame (nbre/cm) | 44 × 45 | 44 × 45 |
| TC 25 | 0,8 | 0,8 |
| Poids d'enduction PU (g/m2) | 0 | 5,9 |
| Module PU à 100% allongement (MPa) | NA | 2 |
| % réticulant (en poids sec) | NA | 8,4 |
| Poids de la couche de protection (g/m²) | 33,0 | 38,7 |
| Résistance mécanique à la déchirure chaine (daN) | 3,0 | 3,7 |
| Résistance mécanique à la déchirure trame (daN) | 2,3 | 4,2 |
| Porosité à l'air à neuf (L/m2/min) sous 2000 Pa | > 200 | 3 |
| Porosité à l'air après vieillissement (L/m2/min) sous 2000 Pa | > 200 | 48 |
| Résistance électrique moyenne des cinq pistes en contact direct (recto du tissu) (face d'impression) (Ohm) | 16,1± 0,1 | 8,4± 0,2 |
| Résistance électrique moyenne des cinq pistes en contact indirect (verso du tissu) (face non-imprimée) (Ohm) | 16,8± 0,2 | pas de signal détecté |

La mesure de résistance moyenne effectuée sur la face enduite du tissu enduit est nulle, démontrant le caractère isolant et protecteur de l'enduction. De plus, la valeur de résistance sur la face imprimée est plus faible pour le tissu enduit selon l'invention par rapport au tissu témoin non-enduit. Il est donc constaté que l'enduction permet d'apporter une propriété barrière aux charges. Sans vouloir être lié à la théorie, on pense également que la couche de protection, sans doute en améliorant la stabilité dimensionnelle du tissu et la tenue de la couche de protection, améliore la qualité du dépôt de l'encre conductrice lors de l'impression et améliore la conductivité des pistes.

Il est également constaté que le composant selon l'invention a une résistance mécanique à la déchirure supérieure à 2,5 daN, donc de 25 kg.m.s⁻², résistance mécanique conforme voire supérieure pour les applications envisagées.

### Exemple 2 : Illustration de la propriété barrière aux charges électriques

L'exemple 2 compare les caractéristiques d'un tissu de verre imprimé par une encre conductrice sur une face et recouvert d'une enduction polyuréthane sur la face opposée (composant selon l'invention) par rapport à un tissu de verre imprimé par une encre conductrice et non-enduit sur la face opposée (témoin). Dans cet exemple, c'est l'encre qui a été déposée en premier sur le tissu.

L'encre conductrice déposée est dans les deux cas une encre d'une résistivité de 150 mOhm/sq/25µm (mΩ/□/25µm). Les pistes sont des lignes parallèles de longueur de 70 mm et de pas de 2,54 mm, l'épaisseur d'encre imprimée est de 100 µm. La distance inter piste est de 3 mm. Le nombre de lignes imprimées est de douze.

Le témoin est un tissu de verre d'épaisseur environ 128 µm.

Le composant selon l'invention comprend le même tissu de verre que le témoin. Il reçoit en plus une couche de protection par enduction polyuréthane obtenue à partir d'un élastomère de PU ayant un module à 100% d'allongement de 2 MPa et de réticulant isocyanate + mélamine formaldéhyde. La proportion de réticulant sec par rapport à l'élastomère sec est de 8,4%. Le polyuréthane est mis en oeuvre dans un mélange 50/50 de toluène et d'isopropanol. Le PU est un PU monocomposant à base de polycarbonate aliphatique. L'enduction est réalisée en utilisant une racle et est suivie d'un séchage à l'air puis d'une réticulation à 180 °C.

**[Table 2]**

| | Témoin | Composant de l'invention, Exemple 2 |
|---|---|---|
| Nature du fil | Verre | Verre |
| Titre du fil (tex) | 68 | 68 |
| TPF (tex) | 0,17 | 0,17 |
| Diamètre d'un filament (µm) | 9 | 9 |
| Nombre fils de chaîne x fils de trame (nbre/cm) | 11,8 × 11,5 | 11,8 × 11,5 |
| TC 25 | 0,82 | 0,82 |
| Poids d'enduction sur la face opposée (g/m2) | 0 | 28 |
| Module PU à 100% allongement (MPa) | NA | 2 |
| % réticulant (en poids sec) | NA | 8,4 |
| Poids total(g/m2) | 121 | 149 |
| Résistance électrique moyenne des douze pistes en contact direct (recto du tissu) (face d'impression) (Ohm) | 1,8± 0,2 | 1,8± 0,2 |
| Résistance électrique moyenne des douze pistes en contact indirect (verso du tissu) (face non imprimée) (Ohm) | 2,1± 0,2 | pas de signal détecté |

La mesure effectuée sur la face enduite du tissu enduit est nulle, démontrant le caractère isolant et protecteur de l'enduction. Il est donc démontré que l'enduction permet d'apporter une propriété barrière aux charges.

Exemples 3 & 4 : Illustration des propriétés de légèreté, de résistance mécanique élevée, de durabilité élevée et de propriétés barrières notamment vis-à-vis de l'oxygène de l'air, de l'humidité et de la présence d'eau.

Ces exemples comparent les caractéristiques de tissus polyamide recouverts d'une enduction polyuréthane selon l'invention par rapport à un tissu polyamide non-enduit.

Le témoin est un tissu PA6.6 d'épaisseur environ 70 µm. La ténacité du fil PA6.6 est de 6,6 cN/dtex. L'allongement à la rupture est de 26%.

Dans l'exemple 3, le même tissu PA6.6 est associé à une couche de protection par enduction polyuréthane obtenue à partir d'un élastomère de PU ayant un module à 100% d'allongement de 2 MPa et de réticulant isocyanate + mélamine formaldéhyde. La proportion de réticulant sec par rapport à l'élastomère sec est de 8,4%. Le polyuréthane est mis en oeuvre dans un mélange 50/50 de toluène et d'isopropanol.

Dans l'exemple 4, le même tissu PA6.6 est associé à une couche de protection par enduction polyuréthane obtenue à partir d'un élastomère de PU ayant un module à 100% d'allongement de 32,4 MPa et de réticulant isocyanate + mélamine formaldéhyde. La proportion de réticulant sec par rapport à l'élastomère sec est de 79,4%. Le polyuréthane est mis en oeuvre dans un mélange 50/50 de toluène et d'isopropanol.

Dans les exemples 3 et 4, le PU est un PU monocomposant à base de polycarbonate aliphatique. L'enduction est réalisée en utilisant une racle et est suivie d'un séchage à 100°C, puis d'une réticulation à 180 °C.

**[Table 3]**

| | Témoin | Exemple 3 | Exemple 4 |
|---|---|---|---|
| Nature du fil | PA6.6 | PA6.6 | PA6.6 |
| Titre (dtex) | 33 | 33 | 33 |
| DPF (dtex) | 2,5 | 2,5 | 2,5 |
| Diamètre d'un filament (µm) | 19 | 19 | 19 |
| Nombre fils de chaîne x fils de trame (nbre/cm) | 44 × 45 | 44 × 45 | 44 × 45 |
| TC 25 | 0,79 | 0,79 | 0,79 |
| Poids d'enduction (g/m2) | 0 | 5,9 | 6,5 |
| Module PU à 100% allongement (MPa) | NA | 2 | 32,4 |
| % réticulant (en poids sec) | NA | 8,4 | 79,4 |
| Poids total (g/m2) | 33,0 | 38,7 | 38,9 |
| Résistance mécanique à la déchirure sens chaîne (daN) | 3,0 | 3,7 | 2,9 |
| Résistance mécanique à la déchirure sens trame (daN) | 2,3 | 4,2 | 2,7 |
| Porosité à l'air à neuf (L/m2/min) sous 2000 Pa | > 200 | 3 | 4 |
| Porosité à l'air après vieillissement (L/m2/min) sous 2000 Pa | > 200 | 48 | 52 |

Il est constaté que les composants des exemples 3 et 4 selon l'invention ont des résistances mécaniques à la déchirure supérieures à 2,5 daN, donc de 25 kg.m.s⁻², résistance mécanique conforme voire supérieure pour les applications envisagées.

Il est constaté que les composants des exemples 3 et 4 selon l'invention ont des propriétés barrière à l'air et à l'oxygène, à neuf et après vieillissement, inférieures à 150 L/m²/min, porosité à l'air et l'oxygène conforme pour les applications envisagées.

Exemples 5 & 6 : Illustration des propriétés de légèreté, de résistance mécanique élevée, de durabilité élevée et de propriétés barrières notamment vis-à-vis de l'oxygène de l'air, de l'humidité et de la présence d'eau.

Ces exemples comparent les caractéristiques de tissus polyester imprimés recouverts d'une enduction polyuréthane selon l'invention par rapport à un tissu polyester non-enduit.

Le témoin est un tissu PET d'épaisseur environ 70 µm. La ténacité du fil PET est de 6,8 cN/dtex. L'allongement à la rupture est de 24,6%.

Dans l'exemple 5, le même tissu PET est associé à une couche de protection par enduction polyuréthane obtenue à partir d'un élastomère de PU ayant un module à 100% d'allongement de 2 MPa et de réticulant isocyanate + mélamine formaldéhyde. La proportion de réticulant sec par rapport à l'élastomère sec est de 8,4%. Le polyuréthane est mis en oeuvre dans un mélange 50/50 de toluène et d'isopropanol.

Dans l'exemple 6, le même tissu PET est associé à une couche de protection par enduction polyuréthane obtenue à partir d'un élastomère de PU ayant un module à 100% d'allongement de 2 MPa et de réticulant isocyanate + mélamine formaldéhyde. La proportion de réticulant sec par rapport à l'élastomère sec est de 22,5%. Le polyuréthane est mis en oeuvre dans un mélange 50/50 de toluène et d'isopropanol.

Dans les exemples 5 et 6, le PU est un PU monocomposant à base de polycarbonate aliphatique. L'enduction est réalisée en utilisant une racle et est suivie d'un séchage à 100°C puis d'une réticulation à 180 °C.

**[Table 4]**

| | Témoin | Exemple 5 | Exemple 6 |
|---|---|---|---|
| Nature du fil | PET | PET | PET |
| Titre du fil (dtex) | 33 | 33 | 44 |
| DPF (dtex) | 2,1 | 2,1 | 1,8 |
| Diamètre d'un filament (µm) | 16 | 16 | 16 |
| Nombre fils de chaîne x fils de trame (nbre/cm) | 44 × 44,5 | 44 × 44,5 | 39 × 38,5 |
| TC 25 | 0,79 | 0,79 | 0,82 |
| Poids d'enduction sur la face opposée (g/m2) | 0 | 8 | 14 |
| Module PU à 100% allongement (MPa) | NA | 2 | 2 |
| % réticulant (en poids sec) | NA | 8,4 | 22,5 |
| Poids total (g/m2) | 31,0 | 39,6 | 50,7 |
| Résistance mécanique à la déchirure sens chaîne (daN) | 3,2 | 2,8 | 2,5 |
| Résistance mécanique à la déchirure sens trame (daN) | 2,7 | 2,6 | 1,8 |
| Porosité à l'air à neuf (L/m2/min) sous 2000 Pa | > 200 | 1 | 1 |
| Porosité à l'air après vieillissement (L/m2/min) sous 2000 Pa | > 200 | 4 | 2 |

Il est constaté que les composants des exemples 5 et 6 selon l'invention ont des résistances mécaniques à la déchirure supérieures à 1,5 daN, donc de 15 kg.m.s⁻², résistance mécanique conforme voire supérieure pour les applications envisagées.

Il est constaté que les composants des exemples 5 et 6 selon l'invention ont des propriétés barrière à l'air et à l'oxygène, à neuf et après vieillissement, largement inférieures à 150 L/m2/min, porosité à l'air et l'oxygène conforme pour les applications envisagées.

Exemple 7 : Evaluation du vieillissement d'éprouvettes sérigraphiées - Influence de l'encre conductrice sur les performances mécaniques et influence de l'enduction sur la conductivité de l'encre :
On a utilisé un tissu PA6.6 et une enduction PU conformes à l'exemple 1 selon l'invention. Des éprouvettes d'encre conductrice ont été imprimées par sérigraphie, de façon à obtenir des rectangles de 200 × 50 mm.

Les éprouvettes sont ensuite fixées sur une plaque de métal, face enduite PU exposée au vieillissement et face imprimée d'encre conductrice au contact et donc protégée par la plaque de métal. La fixation a été réalisée à l'aide de ruban adhésif étanche à l'eau et à l'air. Les éprouvettes ainsi préparées ont été exposées en enceinte climatique pendant 40h à des cycles en alternance de 4h d'exposition aux UV et d'exposition à la condensation, selon les conditions suivantes:
- 4h d'exposition aux UV : UVA (340nm), 60°C et 20% d'humidité relative (HR)) et
- 4h d'exposition à la condensation : 40°C et 100% HR.

Les essais de traction sens chaîne et sens trame ont été réalisés selon la norme NF EN ISO 13934-1 comme décrit *supra* et les mesures de résistance électrique ont été faites selon la méthode décrite *supra.* Ces mesures ont été réalisées sur les échantillons suivants :
- 4 éprouvettes de tissu enduit, noté Tₑ
- 4 éprouvettes de tissu enduit avec impression d'encre conductrice, noté Tₑᵢ
- 4 éprouvettes de tissu enduit avec impression d'encre conductrice et après vieillissement, noté Tₑᵢᵥ
- 4 éprouvettes de tissu non enduit, noté Tₙₑ
- 4 éprouvettes de tissu non enduit avec impression d'encre conductrice, noté Tₙₑᵢ
- 4 éprouvettes de tissu non enduit avec impression d'encre conductrice et après vieillissement, noté Tₙₑᵢᵥ

Les résultats sont reportés dans le tableau ci-dessous :

| | Te | | Tei | | Teiv | |
|---|---|---|---|---|---|---|
| | Moyenne | Ecart type | Moyenne | Ecart type | Moyenne | Ecart type |
| Epaisseur d'encre (µm) | NA | NA | 14 | 0 | 14 | 0 |
| Résistance mécanique à la déchirure sens chaîne (daN) | 4,0 | 0,1 | 4,5 | 0,1 | 4,3 | 0,2 |
| Résistance mécanique à la déchirure sens trame (daN) | 4,5 | 0,1 | 4,4 | 0,0 | 4,8 | 0,1 |
| Résistance électrique moyenne des éprouvettes en contact direct (recto du tissu) (face d'impression) (Ohm) | NA | NA | 0,65 | 0,20 | 0,60 | 0,25 |
| | | | | | | |

| | Tₙₑ | | Tnei | | Tₙₑᵢᵥ | |
|---|---|---|---|---|---|---|
| | Moyenne | Ecart type | Moyenne | Ecart type | Moyenne | Ecart type |
| Epaisseur d'encre (µm) | NA | NA | 17 | 2 | 17 | 2 |
| Résistance mécanique à la déchirure sens chaîne (daN) | 3,9 | 0,1 | ND | ND | 3,6 | 0,5 |
| Résistance mécanique à la déchirure sens trame (daN) | 3,6 | 0,2 | ND | ND | 4,3 | 0,1 |
| Résistance électrique moyenne des éprouvettes en contact direct (recto du tissu) (face d'impression) (Ohm) | NA | NA | 2,02 | 0,54 | 1,83 | 0,58 |

| | | | | | | |
|---|---|---|---|---|---|---|
| NA : non applicable ; ND : non déterminé | | | | | | |

Ainsi, les résultats obtenus permettent de mettre en évidence que :
- Les résistances mécaniques sens chaîne et trame ne sont pas influencées par l'impression d'encre conductrice
- Le vieillissement n'influence pas les performances mécaniques du textile.
- Ces essais confirment les valeurs présentées dans l'exemple 1, à savoir que l'enduction PU améliore les résistances mécaniques du tissu.
- Le vieillissement ne modifie pas l'épaisseur des échantillons
- On observe une meilleure conductivité en présence de l'enduction et une stabilité de celle-ci après vieillissement.

## Revendications

1. Composant électronique drapable, comprenant:
• une couche d'électronique formée par impression d'encre et
• une couche de protection
**caractérisé en ce que** :
• la couche de protection forme un complexe qui comprend un tissu et une couche de polymère de protection, revêtant une face du tissu
• la couche d'électronique est déposée sur le tissu, sur la face du tissu opposée à la face de dépôt de la couche de polymère de protection
• le tissu est obtenu par tissage de fils continus et est **caractérisé par** un taux de couverture TC25 supérieur ou égal à 0,5, typiquement de 0,5 à 3, notamment compris entre 0,6 et 2,5, plus particulièrement entre 0,7 et 2, par exemple entre 0,7 et 1,5, le TC25 étant calculé comme suit : TC25 = [(nombre de filaments/cm × diamètre d'1 filament en cm)_{chaîne} + (nombre de filaments/cm × diamètre d'1 filament en cm)ₜᵣₐₘₑ] × 25 / épaisseur dudit tissu en µm.

2. Composant selon la revendication 1, **caractérisé en ce que** le tissu a une épaisseur comprise entre 25 et 500 µm, notamment entre 25 et 300 µm, en particulier entre 25 et 150 µm, plus particulièrement entre 25 et 50 µm.

3. Composant selon la revendication 1 ou 2, **caractérisé en ce que** le tissu a une densité surfacique comprise entre 20 et 450 g/m², notamment entre 20 et 250 g/m², en particulier entre 20 et 100 g/m².

4. Composant selon l'une quelconque des revendications précédente, **caractérisé en ce que** si le tissu est confectionné avec des fils synthétiques, le nombre de fils au cm en chaîne et en trame est compris entre 10 et 50 fils/cm, et si le tissu est confectionné avec des fils inorganiques ou naturels, le nombre de fils au cm en chaîne et en trame est compris entre 6 et 30, notamment entre 10 et 25 fils/cm.

5. Composant selon la revendication 4, **caractérisé en ce que** les fils synthétiques, notamment en polyamide ou en polyester, ont une masse linéique comprise entre environ 11 et environ 800 dtex, notamment entre environ 22 et environ 110 dtex, en particulier entre environ 22 et environ 78 dtex, et une masse linéique des filaments constitutifs (DPF ou decitex par filament) comprise entre 1 et 4, de préférence entre 1,3 et 3,5 dtex.

6. Composant selon la revendication 4, **caractérisé en ce que** les fils en matériau inorganique, notamment le verre et le basalte, ou en matériau naturel, notamment cellulose ou lin, ont une masse linéique comprise entre environ 2 et environ 300 tex, notamment entre environ 10 et environ 90 tex, en particuliers entre environ 20 et environ 80 tex, et une masse linéique des filaments constitutifs (TPF ou tex par filament) est comprise entre 0,05 et 0,2.

7. Composant selon l'une quelconque des revendications précédentes, **caractérisé en ce que** le taux d'emport sec du polymère de protection est compris entre 5 et 50%, de préférence entre 5 et 30 % en poids, mieux entre 10 et 30 %, le taux d'emport sec étant le ratio en poids du polymère de protection sec sur le tissu.

8. Composant selon l'une quelconque des revendications précédentes, **caractérisé en ce que** le polymère de protection est sous la forme d'un revêtement enduisant ou imprégnant le tissu, et de préférence comprend ou est constitué de : polyuréthane, polyester, polycarbonate, polyéther, polyéthylène, polypropylène, alcool polyvinylique, poly(acétate de vinyle), poly(éthylène-acétate de vinyle), poly(acrylate-méthacrylate), poly(chlorure de vinyle), caoutchouc synthétique, silicone, copolymères de ces polymères.

9. Composant selon la revendication précédente, **caractérisé en ce que** le polymère de protection est un polyuréthane à base de polyéther, polyester ou polycarbonate.

10. Composant selon la revendication précédente, **caractérisé en ce que** le polyuréthane est issu de la réticulation (1) d'un élastomère de polyuréthane monocomposant ayant un module à 100% d'allongement inférieur ou égal à 50 MPa, notamment compris entre 1 et 40 MPa, en particulier entre 1 et 35 MPa, selon la norme DIN 53504, mis en oeuvre en phase solvant organique, (2) par un réticulant, à raison d'une proportion de réticulant sec par rapport à l'élastomère sec compris entre environ 5 % et environ 100 % en poids, notamment entre environ 7 et environ 80 % en poids, en particulier entre environ 8 et environ 75 % en poids.

11. Composant selon la revendication 8, **caractérisé en ce que** le polymère est constituée par un film laminé sur le tissu, et de préférence comprend ou est constitué de : polyuréthane, polyester, polycarbonate, polyéther, polyéthylène, polypropylène, polychlorure de vinyle, polyfluorure de vinyle, poly(acrylate-méthacrylate).

12. Composant selon l'une quelconque des revendications précédentes, **caractérisé en ce que** le tissu est un tissu obtenu par tissage de fils continus en PET.

13. Composant selon l'une quelconque des revendications précédentes, **caractérisé en ce qu'**il a un poids total compris entre environ 22 et environ 1400 g/m², notamment entre environ 22 et environ 620 g/m², en particulier entre environ 22 et environ 280 g/m².

14. Composant selon l'une quelconque des revendications précédentes, **caractérisé en ce que** l'encre est une encre conductrice, semi-conductrice ou diélectrique.

15. Composant selon l'une quelconque des revendications précédentes, **caractérisé en ce que** la couche de circuit électronique est recouverte par une deuxième couche de polymère protection.

16. Elément d'habillage comprenant un composant électronique drapable selon l'une quelconque des revendications précédentes, ledit élément d'habillage étant configuré pour habiller au moins partiellement un support ou objet.

17. Objet portant à sa surface un composant électronique drapable selon l'une quelconque des revendications ,1 à 15 appliqué sur une surface de l'objet avec la couche d'électronique côté surface.

18. Utilisation d'un composant électronique drapable selon l'une quelconque des revendications 1 à 15, comme couche ayant des effets résistif, capacitif ou inductif, comme capteur, actuateur, antenne pour le stockage et la transmission de données, pour le blindage électromagnétique, comme composant optronique, comme piste électriquement conductrice pour l'utilisation ou la mise en contact de composants électroniques, en particulier LED ou OLED, puces RFID ou NFC, comme composant électronique dans des films photovoltaïques flexibles, comme composant électronique dans des applications OLED flexibles.

## Patentansprüche

1. Drapierbare elektronische Komponente, umfassend:
• eine Elektronikschicht, die durch Tintendruck gebildet ist, und
• eine Schutzschicht
**dadurch gekennzeichnet, dass**:
• die Schutzschicht einen Komplex bildet, das ein Gewebe und eine schützende Polymerschicht umfasst, die eine Seite des Gewebes beschichtet
• die Elektronikschicht auf der Seite des Gewebes auf das Gewebe aufgebracht wird, die der Seite gegenüber ist, auf der die schützende Polymerschicht aufgebracht ist
• das Gewebe durch Weben von Endlosfäden erlangt wird und durch einen Deckungsgrad TC25 von 0,5 oder mehr, normalerweise von 0,5 bis 3, insbesondere von 0,6 bis 2,5, besonders bevorzugt von 0,7 bis 2, beispielsweise von 0,7 bis 1,5, gekennzeichnet ist, wobei der TC25 wie folgt berechnet wird: TC25 = [(Anzahl Filamente/cm x Durchmesser eines Filaments in cm)_{Kette} + (Anzahl Filamente/cm x Durchmesser eines Filaments in cm)_{Schuss}] × 25 / Stärke des Gewebes in µm.

2. Komponente nach Anspruch 1, **dadurch gekennzeichnet, dass** das Gewebe eine Stärke zwischen 25 und 500 µm, insbesondere zwischen 25 und 300 µm, vor allem zwischen 25 und 150 µm, besonders bevorzugt zwischen 25 und 50 µm, aufweist.

3. Komponente nach Anspruch 1 oder 2, **dadurch gekennzeichnet, dass** der Stoff eine Flächendichte zwischen 20 und 450 g/m², insbesondere zwischen 20 und 250 g/m², vor allem zwischen 20 und 100 g/m², aufweist.

4. Komponente nach einem der vorherigen Ansprüche, **dadurch gekennzeichnet, dass**, wenn das Gewebe mit synthetischen Garnen konfektioniert ist, die Anzahl der Garne pro cm in Kette und Schuss zwischen 10 und 50 Garne/cm ist, und wenn das Gewebe mit anorganischen oder natürlichen Garnen konfektioniert ist, die Anzahl der Garne pro cm in Kette und Schuss zwischen 6 und 30, insbesondere zwischen 10 und 25 Garne/cm ist.

5. Komponente nach Anspruch 4, **dadurch gekennzeichnet, dass** die synthetischen Garne, insbesondere aus Polyamid oder Polyester, eine lineare Masse von zwischen etwa 11 und etwa 800 dtex, insbesondere zwischen etwa 22 und etwa 110 dtex, insbesondere zwischen etwa 22 und etwa 78 dtex, und eine längenbezogene Masse der konstituierenden Filamente (DPF oder decitex pro Filament) zwischen 1 und 4, vorzugsweise zwischen 1,3 und 3,5 dtex, aufweisen.

6. Komponente nach Anspruch 4, **dadurch gekennzeichnet, dass** die Fäden aus anorganischem Material, insbesondere Glas und Basalt, oder aus natürlichem Material, insbesondere Zellulose oder Flachs, eine lineare Masse von zwischen etwa 2 und etwa 300 tex, insbesondere zwischen etwa 10 und etwa 90 tex, insbesondere zwischen etwa 20 und etwa 80 tex, und eine längenbezogene Masse der konstituierenden Filamente (TPF oder tex pro Filament) zwischen 0,05 und 0,2 ist.

7. Komponente nach einem der vorherigen Ansprüche, **dadurch gekennzeichnet, dass** der Trockenauftragsgrad des Schutzpolymers zwischen 5 und 50 %, vorzugsweise zwischen 5 und 30 Gewichts-%, besonders bevorzugt zwischen 10 und 30 % ist, wobei der Trockenauftragsgrad das Gewichtsverhältnis des trockenen Schutzpolymers zu dem Gewebe ist.

8. Komponente nach einem der vorherigen Ansprüche, **dadurch gekennzeichnet, dass** das Schutzpolymer in Form einer Beschichtung ist, die das Gewebe beschichtet oder imprägniert, und vorzugsweise Folgendes umfasst oder daraus besteht: Polyurethan, Polyester, Polycarbonat, Polyether, Polyethylen, Polypropylen, Polyvinylalkohol, Poly(vinylacetat), Poly(ethylen-vinylacetat), Poly(acrylat-methacrylat), Poly(vinylchlorid), synthetischem Kautschuk, Silikon, Copolymeren dieser Polymere.

9. Komponente nach dem vorherigen Anspruch, **dadurch gekennzeichnet, dass** das Schutzpolymer ein Polyurethan auf der Basis von Polyether, Polyester oder Polycarbonat ist.

10. Komponente nach dem vorherigen Anspruch, **dadurch gekennzeichnet, dass** dieses Polyurethan aus der Vernetzung (1) eines Einkomponenten-Polyurethans mit einem Modul bei 100 % Dehnung von kleiner als oder gleich wie 50 MPa, insbesondere zwischen 1 und 40 MPa, insbesondere zwischen 1 und 35 MPa, gemäß der Norm DIN 53504, das in organischer Lösungsmittelphase eingesetzt wird, (2) durch einen Vernetzer hervorgegangen ist, in einem Verhältnis von trockenem Vernetzer zu trockenem Elastomer zwischen etwa 5 und etwa 100 Gewichts-%, insbesondere zwischen etwa 7 und etwa 80 Gewichts-%, vor allem zwischen etwa 8 und etwa 75 Gewichts-%.

11. Komponente nach Anspruch 8, **dadurch gekennzeichnet, dass** das Polymer aus einem Film besteht, der auf das Gewebe laminiert ist, und vorzugsweise Folgendes umfasst oder daraus besteht: Polyurethan, Polyester, Polycarbonat, Polyether, Polyethylen, Polypropylen, Polyvinylchlorid, Polyvinylfluorid, Poly(acrylat-Methacrylat).

12. Komponente nach einem der vorherigen Ansprüche, **dadurch gekennzeichnet, dass** das Gewebe ein Gewebe ist, das durch Weben von Endlosfäden aus PET hergestellt wird.

13. Komponente nach einem der vorherigen Ansprüche, **dadurch gekennzeichnet, dass** sie ein Gesamtgewicht zwischen etwa 22 und etwa 1400 g/m², insbesondere zwischen etwa 22 und etwa 620 g/m², vor allem zwischen etwa 22 und etwa 280 g/m², aufweist.

14. Komponente nach einem der vorherigen Ansprüche, **dadurch gekennzeichnet, dass** die Tinte eine leitfähige, halbleitende oder dielektrische Tinte ist.

15. Komponente nach einem der vorherigen Ansprüche, **dadurch gekennzeichnet, dass** die elektronische Schaltungsschicht mit einer zweiten Schicht aus einem Schutzpolymer bedeckt ist.

16. Verkleidungselement, umfassend eine drapierbare elektronische Komponente nach einem der vorherigen Ansprüche, wobei das Verkleidungselement konfiguriert ist, um einen Träger oder ein Objekt zumindest teilweise zu verkleiden.

17. Gegenstand, der auf seiner Oberfläche eine drapierbare elektronische Komponente nach einem der Ansprüche 1 bis 15 trägt, die auf einer Oberfläche des Gegenstands mit der oberflächenseitigen Elektronikschicht aufgebracht ist.

18. Verwendung einer drapierbaren elektronischen Komponente nach einem der Ansprüche 1 bis 15 als Schicht, die resistive, kapazitive oder induktive Wirkungen aufweist, als Sensor, Aktuator, Antenne zur Speicherung und Übertragung von Daten, zur elektromagnetischen Abschirmung, als optronische Komponente, als elektrisch leitfähige Spur zur Verwendung oder Kontaktierung von elektronischen Komponenten, insbesondere LEDs oder OLEDs, RFID- oder NEC-Chips, als elektronische Komponente in flexiblen Photovoltaik-Folien, als elektronische Komponente in flexiblen OLED-Anwendungen.

## Claims

1. A drapable electronic component, comprising:
• an electronic layer formed by printing ink, and
• a protective layer
**characterized in that**:
• the protective layer forms a complex which comprises a fabric and a protective polymer layer coating one side of the fabric
• the electronic layer is deposited on the fabric, on the side of the fabric opposite the deposition side of the protective polymer layer
• the fabric is obtained by weaving continuous yarns and is **characterized by** a cover factor CF25 higher than or equal to 0.5, typically of 0.5 to 3, in particular between 0.6 and 2.5, more particularly between 0.7 and 2, for example between 0.7 and 1.5, CF25 being calculated as follows: CF25 = [(number of filaments/cm × diameter of 1 filament in cm)_{warp} + (number of filaments/cm × diameter of 1 filament in cm)_{weft}] × 25 / thickness of said fabric in µm.

2. The component according to claim 1, **characterized in that** the fabric has a thickness of between 25 and 500 µm, in particular between 25 and 300 µm, more particularly between 25 and 150 µm, further particularly between 25 and 50 µm.

3. The component according to claim 1 or 2, **characterized in that** the fabric has an areal density of between 20 and 450 g/m², in particular between 20 and 250 g/m², in particular between 20 and 100 g/m².

4. The component according to any of the preceding claims, **characterized in that** if the fabric is produced with synthetic yarns, the number of warp and weft yarns per centimetre is between 10 and 50 yarns/cm, and if the fabric is produced with inorganic or natural yarns, the number of warp and weft yarns per centimetre is between 6 and 30, in particular between 10 and 25 yarns/cm.

5. The component according to claim 4, **characterized in that** the synthetic yarns, in particular in polyamide or in polyester, have a linear density of between about 11 and about 800 dtex, in particular between about 22 and about 110 dtex, more particularly between about 22 and about 78 dtex, and a linear density of the constituent filaments (DPF or decitex per filament) of between 1 and 4, preferably between 1.3 and 3.5 dtex.

6. The component according to claim 4, **characterized in that** the yarns in inorganic material, in particular glass and basalt, or in natural material in particular cellulose or flax, have a linear density of between about 2 and about 300 tex, in particular between about 10 and about 90 tex, more particularly between about 20 and about 80 tex, and the linear density of the constituent filaments (TPF or tex per filament) is between 0.05 and 0.2.

7. The component according to any of the preceding claims, **characterized in that** the dry take-up rate of the protective polymer is between 5 and 50 %, preferably between 5 and 30 % by weight, better still between 10 and 30 %, the dry take-up rate being the ratio by weight of the dry protective polymer on the fabric.

8. The component according to any of the preceding claims, **characterized in that** the protective polymer is in the form of a coating which coats or impregnates the fabric, and preferably comprises or is composed of: polyurethane, polyester, polycarbonate, polyether, polyethylene, polypropylene, polyvinyl alcohol, polyvinyl acetate, polyethylene vinyl acetate, poly(acrylate-methacrylate), polyvinyl chloride, synthetic rubber, silicone, copolymers of these polymers.

9. The component according to the preceding claim, **characterized in that** the protective polymer is a polyether-, polyester- or polycarbonate-based polyurethane.

10. The component according to the preceding claim, **characterized in that** the polyurethane is derived from crosslinking (1) a one component polyurethane elastomer having a modulus at 100 % elongation lower than or equal to 50 MPa, in particular between 1 and 40 MPa, in particular between 1 and 35 MPa, according to standard DIN 53504, performed in solvent phase (2) by a crosslinker, in a proportion of dry crosslinker relative to the dry elastomer of between about 5 % and about 100 % by weight, in particular between about 7 and about 80 % by weight, more particularly between about 8 and about 75 % by weight.

11. The component according to claim 8, **characterized in that** the polymer is composed of a film laminated on the fabric, and preferably comprises or is composed of: polyurethane, polyester, polycarbonate, polyether, polyethylene, polypropylene, polyvinyl chloride, polyvinyl fluoride, poly(acrylate-methacrylate).

12. The component according to any of the preceding claims, **characterized in that** the fabric is a fabric obtained by weaving continuous PET yarns.

13. The component according to any of the preceding claims, **characterized in that** it has a total weight of between about 22 and about 1400 g/m², in particular between about 22 and about 620 g/m², more particularly between about 22 and about 280 g/m².

14. The component according to any of the preceding claims, **characterized in that** the ink is a conductive, semiconductor or dielectric ink.

15. The component according to any of the preceding claims, **characterized in that** the electronic circuit layer is coated with a second protective polymer layer.

16. A covering element comprising a drapable electronic component according to any of the preceding claims, said covering element being configured to cover a substrate or object at least in part.

17. An object having on its surface a drapable electronic component according to any of claims 1 to 15 applied onto a surface of the object with the electronic layer on the surface side.

18. Use of a drapable electronic component according to any of claims 1 to 15, as layer having resistive, capacitive or inductive effects, as sensor, actuator, antenna for data storage and transmission, for electromagnetic shielding, as optronic component, as electrically conductive track for the use or contacting of electronic components, in particular LED or OLED, RFID or NFC chips, as electronic component in flexible photovoltaic films, as electronic component in flexible OLED applications.
